# EUROPEAN PATENT APPLICATION

(11) **EP 0 601 649 A1**
(43) Date of publication of application: **15.06.1994**
(21) Application number: 93203395.4
(22) Date of filing: 03.12.1993
(51) Int. Cl.: G09G 3/36, G06F 11/20

(54) **Repairable redundantly-driven matrix display**

(30) Priority: 10.12.1992 US 988631
(71) Applicant: Philips Electronics N.V., 5621 BA Eindhoven (NL)
(72) Inventor: Carlson, Allan, NL-5656 AA Eindhoven (NL)
(74) Representative: Kooiman, Josephus Johannes Antonius

(57) **Abstract**

A matrix display apparatus includes duplicate addressing circuits for redundantly driving pixel row conductors from opposite ends. Each of the addressing circuits includes a shift register having successive stages coupled to the row conductors through respective buffer devices. In order to circumvent defects which would prevent a logical ONE row selection pulse from propagating through individual stages in either or both of the shift registers, pairs of connection devices are provided at the inputs of selected stages of the shift registers. Each pair enables the input of a selected stage to be disconnected from the previous stage and to be connected to the previous row conductor to receive the row selection pulse from the shift register stage coupled to the opposite end of the row conductor. The disclosed apparatus also includes connection devices which can be used to force selected buffer devices to a high-output-impedance mode. This will prevent defectively-operating buffer devices from excessively loading the outputs of the buffer devices at the other end of each respective row conductor.

## Description

### Background of the Invention

The invention relates to matrix displays having pixels which are addressable by means of an array of row and column conductors and, in particular, to such displays having redundant pixel-addressing means.

Currently, the best known matrix display of the above-described type is the liquid crystal display (LCD) which utilizes thin-film transistors (TFTs) to activate associated LCD pixels. Ordinarily, the pixels and their associated TFTs are located at places where transversely-arranged row and column conductors cross, and specific pixels are selected by addressing the respective intersecting row and column conductors. For a detailed description of LCD structure and of circuitry for addressing TFT-activated pixels, one may refer to texts such as E. Kaneko, Liquid Crystal TV Displays, D. Reidel Publishing Company, Kluwer Academic Publishers Group, 1987.

Because of the complexity of matrix arrangements of pixels, associated TFTs, row and column conductors, and the circuitry needed to address the pixels, it is desirable to fabricate as much of the arrangement as possible by thin-film technology on a substrate of the LCD panel itself. To maximize yield, it is known to incorporate in the matrix arrangements duplicate or redundant circuitry for simultaneously addressing the row/column conductors from both ends.

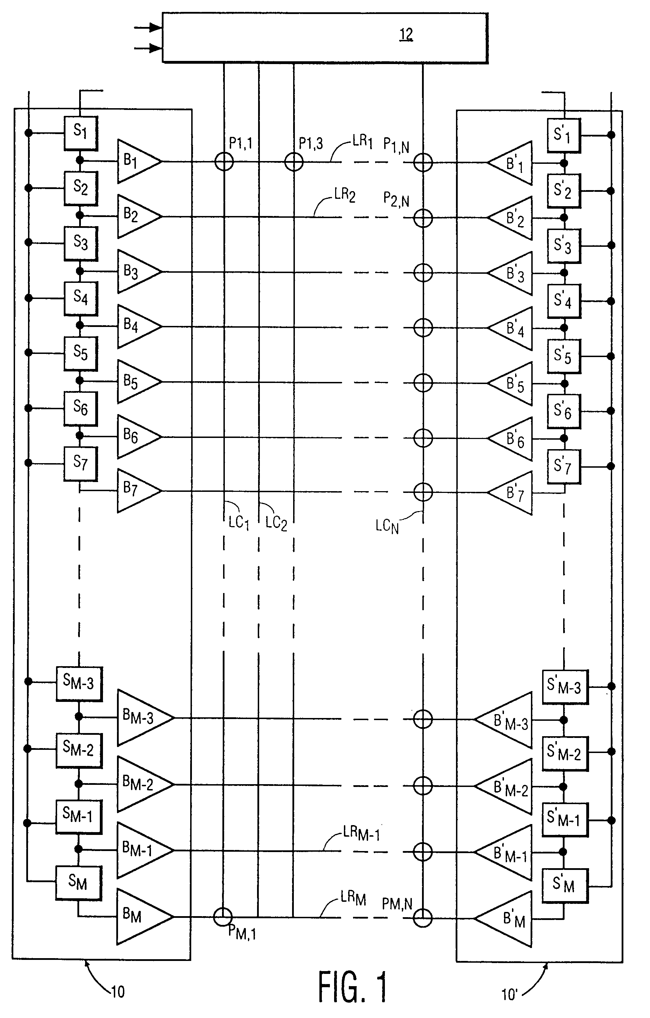

Figure 1 illustrates a known liquid crystal display apparatus which includes redundant row-addressing circuitry. The display apparatus includes a multiplicity of pixels (and their associated TFTs) which are each identified by a respective designation P_{m,n} where m and n identify the specific row and column conductors over which each pixel is addressed. The row and column conductors are designated LR₁, LR₂, ... LR_{M} and LC₁, 10 LC₂, LC₃, ... LC_{N}, respectively. The redundant row-addressing circuitry includes duplicate circuits 10 and 10', each of which has an input for receiving row clock pulses, an input for receiving periodic start pulses, and a multiplicity of outputs electrically connected to respective row conductors. The display apparatus also includes a column-addressing circuit 12 having a first input for receiving column timing pulses, a second input for receiving an image signal, and a multiplicity of outputs electrically connected to respective column conductors.

A typical use for a LCD apparatus is projecting or directly displaying a television image. For such a use, the image signal is derived from the video signal, while the column timing pulses, the row clock pulses, and the start pulses are derived from the vertical and horizontal synch pulses. The image signal has a time-varying voltage which is to be continually sampled and applied over the column conductors to sequentially-addressed pixels of the display. In some systems, a line of video information is stored in a line memory to enable simultaneous (parallel) addressing of the column conductors.

Row-addressing circuit 10 includes an M-stage shift register, having stages S₁, S₂, ... S_{M,} and M output buffer devices B₁, B₂, ... B_{M} through which outputs of respective ones of the shift register stages are coupled to the row conductors LR₁, LR₂, ... LR_{M}. The output of each stage Sₘ is electrically connected to the input of a successive stage Sₘ₊₁ so that a logical ONE can be continually propagated through the shift register under the control of the row clock pulses.

Each buffer device Bₘ has an input electrically connected to the output of a respective shift register stage Sₘ and has an output electrically connected to a respective row conductor LRₘ. As the logical ONE propagates through the shift register, it appears successively at the inputs of the buffer devices B₁, B₂, ... B_{M}, and successively addresses the rows of pixels located along the respective row conductors. More precisely, as the voltage level corresponding to a logical ONE appears at the output of each shift register stage, it causes the connected buffer device to produce a predetermined output voltage which will switch ON the TFTs associated with the pixels in the selected row.

Column-addressing circuit 12 functions similarly to row-addressing circuit 10. However, in addition to addressing the column conductors LC₁, LC₂, ... LC_{N}, it supplies to these conductors data signals representative of samples of the image signal. Specifically, while any row of pixels is addressed by circuit 10, the column-addressing circuit applies to the column conductors for these pixels, data signals representative of brightnesses, e.g. gray levels, corresponding to the segments of the image to be displayed by these pixels. A specific column-addressing circuit will not be described, because it is not needed for an understanding of the invention. Many varieties of such data-supplying, column-addressing circuits are known.

Row-addressing circuit 10' is a duplicate of row-addressing circuit 10 and receives the same row clock signal. This duplicate circuit is provided to ensure that each row conductor is addressed at the appropriate time, even if row-addressing circuit 10 has a defect which prevents it from addressing one or more row conductors. Ideally, the duplicate row-addressing circuit would provide complete redundancy, so that there will be no deterioration of the image displayed by the pixels even if row-addressing circuit 10 fails completely. Unfortunately, however, this is often not the result.

There are two general categories of defects which cannot be cured by the duplicate row-addressing circuit. First, if the duplicate circuit is itself imperfect, such that a defect exists in both circuit 10 and circuit 10', at least one complete row of pixels can be adversely affected. In fact, many rows could be made completely inoperable by only one defect in each of the two row-addressing circuits. For example, if a defect in shift register stage S₃ prevents the appearance at its output of the propagating logical ONE, neither this stage nor any following stage will be able to address its respective row of pixels. Row conductors LR₃ through LR_{M} will be addressable only by duplicate row-addressing circuit 10'. However, if the duplicate circuit has a defect in its shift register stage S₄' which similarly stops the propagation of the logical ONE in the duplicate shift register, the last addressable row of pixels in the display will be those in row 3. All subsequent rows of pixels will be inoperable.

The second general category of defects which cannot be cured by the duplicate row-addressing circuit relates to buffer devices which become locked in a low-output-impedance mode. This can happen, for example, to any buffer device which has a CMOS output inverter. Such locking can be caused by a defect in the device itself or in a shift register stage to which its input is electrically connected. The low impedance will provide a path from the row conductor connected to the output of the buffer device to one of the supply voltages for the buffer device. This could load down the output of the buffer device at the opposite end of the respective row conductor and make some or all of the pixels in the row inoperable.

### Summary of the Invention

It is an object of the invention to provide a matrix display having improved means for redundantly addressing pixels in the display.

In accordance with the invention, the means for addressing the row and column conductors comprises, at least for a plurality of successively-addressed ones of the conductors, first and second addressing circuits comprising respective shift registers. Each of these shift registers includes a plurality of successive stages having respective outputs coupled to the successively-addressed conductors. Further, each of the first and second addressing circuits includes alternative connection means for electrically disconnecting the inputs of predetermined ones of its shift register stages from the outputs of the preceding stages to which they are normally connected, and for connecting these inputs to the row conductors addressed by the respective preceding stages. This enables the inputs to be disconnected from the outputs of preceding stages which are not propagating the logical ONE timing pulses, and to be coupled to the outputs of the corresponding preceding stages in the other shift register.

In a preferred embodiment of the invention, each of the alternative connection means comprises an openable connection means, such as a severable conductor, and a closeable connection means, such as first and second conductors which are arranged to facilitate fusion to each other. In addition to the alternative connection means, at least some of the shift register stages in the first and second addressing circuits may be coupled to their respective row conductors through buffer devices which can be selectively forced to a high output impedance state.

### Brief Description of the Drawing

Figure 1 is a schematic diagram of a prior art liquid crystal display with redundant pixel-addressing means.

Figure 2 is a schematic diagram of a preferred embodiment of a liquid crystal display apparatus in accordance with the invention.

Figure 3 is a schematic diagram of a buffer device which is useful in the liquid crystal display apparatus of Figure 2.

### Description of the Preferred Embodiment

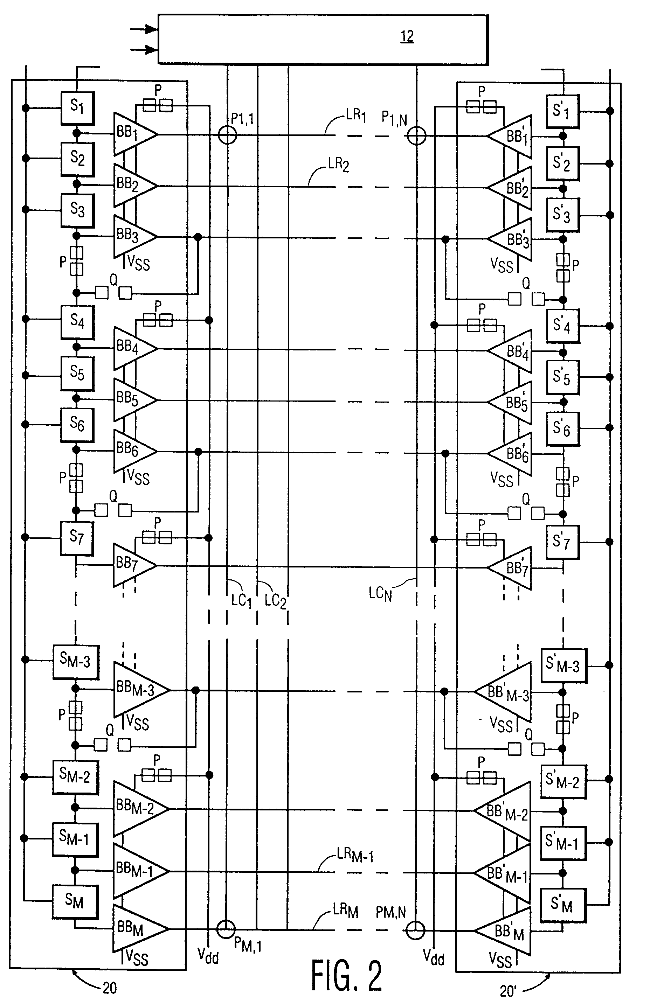

Figure 2 illustrates an exemplary embodiment of a matrix display apparatus having improved means for redundantly addressing rows of the pixels in the display. Parts in the apparatus which are substantially identical to corresponding parts in the apparatus of Figure 1 are marked identically.

As can be seen by examining Figure 2, the significant differences are in the row addressing circuits, which have been renumbered 20 and 20'. In particular, a number of openable connection devices P and closeable connection devices Q are strategically located in circuitry which interconnects or supplies power to the circuit elements of the row-addressing circuits and the row conductors.

Each of the openable connection devices P comprises a pair of conductive pads which are electrically connected to each other by a severable conductor. Alternatively, these devices could be simply portions of a conductor which is accessible for severing. The conductor can be severed mechanically, or by passing an overcurrent through the conductor, or by another technique such as vaporizing the conductor with a laser. Each of the closable connection devices Q comprises a pair of conductive pads which are normally electrically insulated from each other, but which can be electrically connected to each other by wire bonding, by applying conductive paint, or by another technique such as laser fusing. The latter technique is particularly applicable if the conductive pads are disposed on opposite sides of an insulating layer and are weldable to each other by focusing a laser beam at the pads and the intervening layer. An example of such a welding technique is described in detail in D. E. Castleberry et al., "A 1 Mega-Pixel Color a-Si TFT Liquid Crystal Display", 1988 SID Digest of Technical Papers, pages 232 - 234, paper 13.1.

In order to circumvent defects which stop propagation of the logical ONE through one or both of the shift registers in the row-addressing circuits, selected shift register stages have their inputs electrically connected to the outputs of respective preceding stages through openable connection devices P. Additionally, each of these shift register inputs is electrically connected to a first pad of a closable connection device Q. The other pad of each of these devices is electrically connected to the row conductor addressed by the preceding shift register stage.

In this exemplary embodiment, a pair of the connection devices is connected, as described above, to the input following every third stage, and this is done for the shift register in each of the row-addressing circuits. Many other configurations are possible, but the probability of being able to repair defects increases with the number of pairs of the P and Q connection devices which are connected to respective shift register stages.

As an example of how the configuration illustrated in Figure 2 could be used to circumvent defects, consider again the case where shift register stages S₃ and S₄' are defective, making rows 4 through M inoperable. In the apparatus of Figure 2 these defects can be circumvented, making all rows operable, by opening the connection devices P at the inputs of stages S₄ and S₇' and by closing the connection devices Q at these same inputs. Stage S₄ will then be isolated from any spurious signals at the output of defective stage S₃ and will receive the propagating logical ONE from stage S₃'. Similarly, stage S₇' will be isolated from any spurious signals propagated from the output of defective stage S₄' to the output of stage S₆' and will receive the propagating logical ONE from stage S₆. All other stages in the two shift registers will receive propagating logical ONEs from their respective preceding stages.

To enable curing of the problem which arises when a buffer device becomes locked in a low-output-impedance mode, the buffer devices in the preferred embodiment (i.e. BB₁, .BB₂, ... BB_{M} and BB₁', BB₂', ... BB_{M}') are of a type which can be forced to a high output-impedance mode by controlling the application of a power supply voltage to the device. This can be done by disconnecting the supply voltage V_{dd} from selected ones of the buffer devices. To enable such disconnection, groups of the buffer devices are electrically connected, through respective openable connection devices P, to a conductor over which the voltage V_{dd} is supplied. In the exemplary embodiment of Figure 2, each group includes three of the buffer devices.

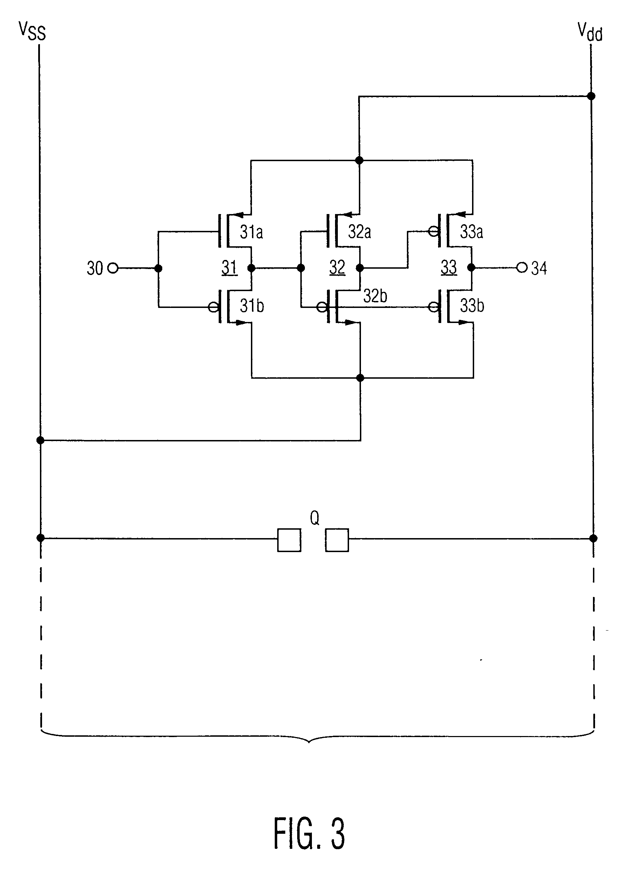

An exemplary embodiment of a buffer device which will operate as described above is illustrated in Figure 3. This device includes an input terminal 30, a first CMOS inverter 31 including transistors 31a and 31b, a second CMOS inverter 32 including transistors 32a and 32b, a PMOS circuit 33 including transistors 33a and 33b, and an output 37. The source electrodes of transistors 31a and 32a, and the drain electrode of 33a are electrically connected to a source of a voltage Vₛₛ, and the drain electrodes of the transistors 31b, 32b and 33b are electrically connected to a source of a voltage V_{dd}. Input terminal 30 is provided for connection to the output of one of the shift register stages, while output terminal 34 is provided for connection to one of the row conductors.

Each of the inverters 31 and 32 has a single input and a single output, with the output of inverter 31 being electrically connected to the input of inverter 32. The input corresponds to the electrically connected gate electrodes of the two transistors in each inverter, while the output corresponds to the electrically connected drain electrodes of the same transistors. PMOS circuit 33, however, has two inputs and a single output. The first input corresponds to the gate electrode of transistor 33a, which is electrically connected to the output of the second inverter 32. The second input corresponds to the gate electrode of transistor 33b, which is electrically connected to the output of the first inverter 31. The output of the PMOS circuit corresponds to the electrically connected source and drain electrodes of transistors 33a and 33b, respectively.

In normal operation, the signal level at the input 30 will be either a logical ONE (e.g. the voltage V_{dd}, which may be on the order of +15 volts) or a logical ZERO (e.g. the voltage Vₛₛ, which may be approximately 0 volts). PMOS circuit 33 will receive this same signal level at its first input (after double inversion by inverters 31 and 32) and will receive the opposite signal level at its second input (after inversion by inverter 31). The logical output provided by circuit 33 to output 34 will be identical to that existing at the input 30. One of transistors 33a and 33b will be OFF, while the other transistor will be ON and thus providing a low impedance path between the voltage source to which the transistor is connected (i.e. Vₛₛ or V_{dd} volts) and the output terminal 34 (to which one of the row conductors is electrically connected.

A buffer device could become locked in one of the above-mentioned low-output-impedance modes because of either a defect in the shift register stage which is connected to the input of the stage or because of a defect in the buffer device itself. If this happens, the status of the pixels addressed by the connected row conductor will be indeterminate whenever the buffer device at the opposite end of the row conductor is in the opposite low-impedance mode. For example, if buffer device BB₂ becomes locked in a mode which provides a low output impedance path to ground, whenever buffer device BB₂' is in the opposite mode (i.e. providing a low output impedance to V_{dd}) the individual voltages applied to the thin-film pixel transistors addressed by row conductor LR₂ will be somewhere between Vₛₛ and V_{dd}. These individual voltages could be above or below the voltage threshold required to turn ON the respective transistors and to activate the pixels to which the transistors are connected. In fact, some of the transistors could be ON while others are OFF, because a substantial current will flow through the row conductor in this situation and its resistance could be sufficiently high to cause a significant voltage drop along its length.

In order to correct the above-described problem, buffer device BB₂ is forced to a high output impedance mode by opening the connection device P through which the voltage V_{dd} is supplied over a bus to the three buffer devices BB₁, BB₂ and BB₃. This changes the voltage on the V_{dd} bus to approximately the voltage Vₛₛ which remains applied to the three buffers, and prevents either of the output transistors 33a, 33b in each of these three buffer devices from conducting. The voltages on the respective row conductors LR₁, LR₂ and LR₃ will be determined entirely by the respective buffer devices BB₁', BB₂' and BB₃'.

In certain instances when a connection device P for one of the group of buffer devices is opened, the voltage on the opened V_{dd} bus might not change to Vₛₛ because of leakage currents through the transistors in the buffer devices. This could be corrected by, for example, providing a closable connection device Q for each group of the buffers devices, to enable connection of the Vₛₛ and V_{dd} buses after opening the connection device P for the group.

## Claims

1. A matrix display apparatus comprising a multiplicity of pixels, an array of row and column conductors which are insulated from each other and which are electrically coupled to ones of the pixels which are spatially associated with places where the conductors cross each other, and means for addressing the row and column conductors to enable selective application to the pixels of respective signals representative of an image to be presented by the apparatus, characterized in that the means for addressing the row and column conductors comprises, at least for a plurality of successively-addressed ones of said conductors:
a. a first addressing means comprising a shift register including a plurality of successive stages having respective outputs coupled to said successively-addressed conductors;
b. a second addressing means comprising a shift register including a plurality of successive stages having respective outputs coupled to said successively-addressed conductors;
each of said addressing means including alternative connection means for electrically disconnecting the inputs of predetermined ones of the stages in said addressing means from the outputs of respective preceding stages, and for electrically connecting the inputs of said predetermined stages to the row conductor addressed by the respective preceding stages.

2. A matrix display apparatus as in claim 1 where said alternative connection means comprise:
a. a plurality of openable connection means which normally electrically connect the inputs of the predetermined stages to the outputs of the respective preceding stages; and
b. a plurality of closeable connection means which normally electrically insulate the inputs of the predetermined stages from the row conductors addressed by the respective preceding stages.

3. A matrix display apparatus as in claim 1 or 2 where at least one of the first and second addressing means includes a plurality of buffer devices having controllable output impedances, predetermined ones of said shift register stage outputs being coupled through said buffer devices to said respective conductors.

4. A matrix display apparatus as in claim 1 or 2 where at least one of the first and second addressing means includes:
a. a plurality of buffer devices through which the shift register stage outputs are coupled to said respective conductors; and
b. means for forcing selected ones of said buffer devices to high output impedance states.

5. A matrix display apparatus as in claim 1 where the first and second addressing means are coupled to opposite ends of the successively-addressed conductors.

6. A matrix display apparatus as in claim 2 where each of the openable connection means comprises a severable conductor.

7. A matrix display apparatus as in claim 2 where each of the closeable connection means comprises first and second conductors which are arranged to facilitate fusion to each other.

8. A matrix display apparatus comprising a multiplicity of pixels, an array of row and column conductors which are insulated from each other and which are electrically coupled to ones of the pixels which are spatially associated with places where the conductors cross each other, and means for addressing the row and column conductors to enable selective application to the pixels of respective signals representative of an image to be presented by the apparatus, characterized in that the means for addressing the row and column conductors comprises, at least for a plurality of successively-addressed ones of said conductors:
a. a first addressing means comprising a shift register including a plurality of successive stages having outputs coupled through buffer devices to respective ones of said successively-addressed conductors; and
b. a second addressing means comprising a shift register including a plurality of successive stages having outputs coupled through buffer devices to respective ones of said successively-addressed conductors;
each of said addressing means including:
(1) a plurality of openable connection means for electrically disconnecting inputs of predetermined ones of the stages in said addressing means from the outputs of respective preceding stages, said openable connection means being normally closed; and
(2) a plurality of closeable connection means for electrically connecting the inputs of said predetermined stages to the row conductor addressed by the respective preceding stages, said closeable connection means being normally open.

9. A matrix display apparatus as in claim 8 where the buffer devices have controllable output impedances.

10. A matrix display apparatus as in claim 9 including control means for forcing selected ones of said buffer devices to high output impedance states.

11. A matrix display apparatus as in claim 10 where said control means comprise openable connection means for electrically disconnecting selected ones of said buffer devices from a power source for said devices.

12. A matrix display apparatus as in claim 10 where said buffer devices are arranged in groups, each of said groups:
a. including first and second voltage busses which are electrically connected to respective sources of power for the buffers in the group;
b. including an openable connection device through which at least one of the first and second buses is electrically connected to the respective power source; and
c. including a closable connection device through which the first and second busses may be electrically connected to each other.

13. A matrix display apparatus as in claim 8 where the first and second addressing means are coupled to opposite ends of the successively-addressed conductors.

14. A matrix display apparatus as in claim 8 where each of the openable connection means comprises a severable conductor.

15. A matrix display apparatus as in claim 8 where each of the closeable connection means comprises first and second conductors which are arranged to facilitate fusion to each other.
